# FASCICULE DE BREVET EUROPEEN

(11) **EP 2 801 117 B1**
(45) Date de publication et mention de la délivrance du brevet: **09.03.2016**
(21) Numéro de dépôt: 13700059.2
(22) Date de dépôt: 02.01.2013
(51) Int. Cl.: H01L 31/09, H01L 31/101, H01L 31/18

(54) **STRUCTURE SEMICONDUCTRICE, DISPOSITIF COMPORTANT UNE TELLE STRUCTURE ET PROCÉDÉ DE FABRICATION D'UNE STRUCTURE SEMICONDUCTRICE**
HALBLEITERSTRUKTUR, VORRICHTUNG MIT DIESER HALBLEITERSTRUKTUR UND HERSTELLUNGSVERFAHREN DER HALBLEITERSTRUKTUR
SEMICONDUCTOR STRUCTURE, DEVICE COMPRISING SUCH A STRUCTURE, AND METHOD FOR PRODUCING A SEMICONDUCTOR STRUCTURE

(30) Priorité: 04.01.2012 FR 1250086
(43) Date de publication de la demande: 12.11.2014
(73) Titulaire: Commissariat à l'Énergie Atomique et aux Énergies Alternatives, 75015 Paris (FR)
(72) Inventeur: GRAVRAND, Olivier, F-38120 Fontanil-Cornillon (FR); FERRON, Alexandre, F-38320 Brie-et-Angonnes (FR)
(74) Mandataire: Brevalex
(86) Numéro de dépôt international: PCT/EP2013/050020
(87) Numéro de publication internationale: WO 2013/102631

(56) Documents cités:
- US-A1- 2009 256 231
- US-A1- 2010 230 720
- ITSUNO A M ET AL: "Design and Modeling of HgCdTe nBn Detectors", JOURNAL OF ELECTRONIC MATERIALS, SPRINGER US, BOSTON, vol. 40, no. 8, 7 avril 2011 (2011-04-07), pages 1624-1629, XP019921471, ISSN: 1543-186X, DOI: 10.1007/S11664-011-1614-0
- J. PIOTROWSKI ET AL: "<title>Dark currents, responsivity, and response time in graded gap HgCdTe structures</title>", PROCEEDINGS OF SPIE, vol. 7692, 22 avril 2010 (2010-04-22), pages 766031-766031-8, XP055044448, ISSN: 0277-786X, DOI: 10.1117/12.850331
- G.R. SAVICH, J.R. PEDRAZZANI, D.E. SIDOR, S. MAIMON, G.W. WICKS: "Use of unipolar barriers to block dark currents in infrared detectors", SPIE, PO BOX 10 BELLINGHAM WA 98227-0010, USA, vol. 8012, 25 avril 2011 (2011-04-25), - 29 avril 2011 (2011-04-29), pages 80122T-1-10, XP040562779,

## Description

### DOMAINE TECHNIQUE

L'invention se rapporte au domaine de la détection et/ou de la mesure de rayonnements électromagnétiques et aux dispositifs permettant une telle détection et/ou mesure.

L'évolution rapide de l'optoélectronique, liée à l'adaptation des technologies de la micro-électronique aux semiconducteurs à gap direct, a permis la mise en place de dispositifs permettant la détection et/ou la mesure de rayonnements électromagnétiques qui soient compacts ceci dans des gammes de longueurs d'ondes allant des ultra-violets aux infrarouges.

Ces dispositifs mettent généralement en oeuvre des structures semiconductrices aptes à recevoir un rayonnement électromagnétique et à le transformer en un signal électrique.

L'invention se rapporte plus particulièrement à une structure semiconductrice apte à recevoir un rayonnement électromagnétique et à le transformer en un signal électrique, à un composant semiconducteur comportant au moins une telle structure semiconductrice et à un procédé de fabrication d'une telle structure semiconductrice.

### ÉTAT DE LA TECHNIQUE ANTÉRIEURE

Les structures semiconductrices aptes à recevoir un rayonnement électromagnétique et à le transformer en un signal électrique sont généralement des structures semiconductrices de type diode destinées à être polarisées en inverse.

De telles structures, lorsqu'elles sont utilisées pour la détection et/ou la mesure d'un rayonnement électromagnétique présentent un courant d'obscurité. Un tel courant d'obscurité, correspondant au courant de la diode en fonctionnement lorsque la structure n'est pas soumise à un rayonnement électromagnétique, représente la principale source de bruit de la structure et en limite donc le rapport signal sur bruit, et donc la sensibilité. Ce courant d'obscurité, à basse température, c'est-à-dire à une température inférieure à 170 K est essentiellement lié à la zone de charge d'espace. En effet, celle-ci est le siège du courant de génération et de recombinaison de paires électron-trou, du courant tunnel assisté par des pièges et du courant tunnel bande à bande, qui sont à l'origine de la majeure partie du courant d'obscurité à basse température.

Il est connu, pour limiter le courant d'obscurité à basse température, d'utiliser des structures semiconductrices de type barrière, c'est-à-dire des structures semiconductrices comportant une première et une seconde zone du même type de conductivité séparées par une zone barrière. La première zone et la seconde zone, présentant un même type de conductivité, comportent des porteurs majoritaires identiques qui sont par définition les porteurs majoritaires de la structure. La zone barrière comporte une bande interdite adaptée pour faire barrière aux porteurs majoritaires et laisser passer les porteurs minoritaires. Pour ce faire, la zone barrière possède une largeur de bande interdite supérieure à celles de la première et de la seconde zone avec une différence d'énergie, entre les différentes zones, la plus faible possible pour la bande d'énergie correspondant aux porteurs minoritaires, c'est-à-dire, la bande de valence pour des porteurs minoritaires qui sont des trous, et la bande de conduction, pour des porteurs minoritaires qui sont des électrons. Ainsi, la zone barrière crée, par la différence de largeur de bande interdite avec la première et la seconde zone, une forte barrière de potentiel pour les porteurs majoritaires. Celle-ci est faible, voir annulée, pour les porteurs minoritaires, ceci en raison de la faible différence d'énergie pour la bande d'énergie correspondant aux porteurs minoritaires.

De cette manière, lorsque la première zone est polarisée en inverse, par rapport à la seconde zone, et qu'une paire électron-trou est générée par un photon dans la première zone, le porteur minoritaire généré passe de la première zone à la seconde zone, et est accéléré par la polarisation. Le porteur minoritaire est ainsi collecté au niveau de cette dernière. Une telle structure, en s'affranchissant de la présence de la zone de charge d'espace dans le matériau petit gap, s'affranchit également du bruit dont la zone de charge d'espace est le siège, et présente donc un courant d'obscurité à basse température qui est réduit par rapport à une structure de type diode.

Néanmoins, si une telle structure permet d'obtenir, pour un fonctionnement à basse température, un courant d'obscurité réduit, une telle structure est forcément, en raison de la différence de largeur de bande interdite à laquelle elle fait appel pour la formation de la barrière, une hétéro-structure. La structure comporte donc généralement, pour des matériaux comportant des éléments différents et présentant donc généralement des différences de paramètres de maille importantes, des défauts d'interfaces entre les différentes zones de la structure. De tels défauts, étant potentiellement à l'origine de bruit, limitent l'intérêt d'une telle structure.

Il est connu, comme l'enseigne notamment le brevet américain US 4 679 063, pour limiter la quantité de défauts d'interfaces, d'utiliser des matériaux composés des mêmes éléments, tels que les matériaux du type tellurure de cadmium-mercure Cd_{X}Hg_{1-X}Te. De tels matériaux présentent pour des proportions en éléments différents, des différences de paramètres de maille généralement réduites et peuvent comporter, lorsque ces différences sont importantes, une fine couche d'adaptation le long de laquelle la proportion en éléments est variée pour réduire les contraintes, et donc la quantité de défauts, au niveau des interfaces.

Néanmoins, si une structure comportant de tels matériaux présente une densité de défauts d'interface réduite, les matériaux utilisés pour former ladite structure, doivent répondre à deux critères :
- les matériaux doivent présenter une forte variation de largeur de bande interdite en fonction de la proportion en éléments,
- les matériaux doivent offrir, pour au moins un type de conductivité, la possibilité sur une forte variation de la largeur de bande interdite, de présenter une faible différence d'énergie pour la bande d'énergie correspondant au porteur minoritaire.

La solution décrite dans le document US 4 679 063 pour répondre à ce deuxième critère est l'utilisation d'un dopage adapté de la zone barrière. Cette solution est difficile à mettre en oeuvre pour certains matériaux répondant au premier critère, tels que le tellurure de cadmium-mercure, le dopage adéquat présentant des contraintes techniques difficilement compatibles avec la production industrielle.

Le document US2010230720 divulgue une structure de type barrière pour la transformation d'un rayonnement électromagnétique en un signal électrique selon l'état de la technique, correspondant au préambule de la revendication 1.

### EXPOSÉ DE L'INVENTION

Un des buts de l'invention est de fournir une structure semiconductrice apte à recevoir un rayonnement électromagnétique et à le transformer en un signal électrique, de type barrière, dont les matériaux semiconducteurs à partir desquels la structure est réalisée, sont composés des mêmes éléments, qui, sans nécessiter un type de dopage de la zone barrière différent de celui de la première et de la seconde zone est exempte, en fonctionnement, de barrière de potentiel pour les porteurs minoritaires, ceci avec la barrière de potentiel pour les porteurs majoritaires qui reste active même pour des tensions de polarisation de la structure inverses élevées.

A cet effet, l'invention concerne une structure semiconductrice apte à recevoir un rayonnement électromagnétique et à le transformer en un signal électrique, ladite structure comportant une température nominale de fonctionnement, une telle structure comportant :
- une première et une seconde zone d'un même type de conductivité et réalisées respectivement dans un premier et un deuxième matériau semiconducteur, lesdits premier et deuxième matériaux semiconducteurs étant tous deux composés des mêmes éléments, lesdits éléments étant dits constitutifs, une proportion différente en au moins deux de ces éléments constitutifs correspondant à une différence de largeur de bande interdite dudit matériau, le premier matériau étant un matériau semiconducteur à gap direct,
- une zone barrière, disposée entre la première et la seconde zone, destinée à faire office de barrière aux porteurs majoritaires de la première et de la seconde zone sur une épaisseur de barrière, ladite zone barrière étant composée des éléments constitutifs et présentant sur toute l'épaisseur de barrière une proportion en éléments constitutifs telle que la zone barrière présente un minimum de largeur de bande interdite supérieure à la largeur de bande interdite de la première zone et qui est telle que la différence en valeur absolue entre l'énergie de l'extremum de bande d'énergie correspondant au porteur majoritaire pour le minimum de largeur de bande interdite de la zone barrière et l'énergie de ce même extremum de la seconde zone est égale à au moins 10 fois l'énergie thermique à la température nominale de fonctionnement, la proportion en éléments constitutifs pour laquelle la zone barrière présente la largeur de bande interdite la plus faible définissant la proportion barrière,
- une première zone d'interface agencée pour faire interface entre la première zone et la zone barrière sur une première épaisseur d'interface, la première zone d'interface présentant une composition en éléments constitutifs qui est variée, sur toute l'épaisseur d'interface et de la première zone vers la zone barrière, d'une proportion correspondant à celle du premier matériau à la proportion barrière, la première épaisseur d'interface étant au moins égale à la moitié de l'épaisseur de barrière,
et dans laquelle il est prévu une seconde zone d'interface agencée pour faire interface entre la zone barrière et la seconde zone sur une seconde épaisseur d'interface, la seconde zone d'interface présentant une composition en éléments constitutifs qui est variée, sur toute la seconde épaisseur d'interface et de la zone barrière vers la seconde zone , de la proportion barrière à une composition correspondant à celle du second matériau, la seconde épaisseur d'interface étant inférieure à la moitié de l'épaisseur de barrière.

On entend par zone barrière la zone de la structure sur laquelle l'extremum de bande d'énergie correspondant au porteur majoritaire présente une différence avec le bas de la bande de conduction de la seconde zone qui est égale à au moins 10 fois l'énergie thermique à la température maximum de fonctionnement. Par extension, on entend par épaisseur barrière l'épaisseur de la zone barrière.

On entend par matériau semiconducteur à gap direct un matériau semiconducteur dont le maximum d'énergie de la bande de valence et le minimum d'énergie de la bande de conduction se situent à une valeur du vecteur d'onde k sensiblement égale dans le diagramme de dispersion énergétique dudit matériau semiconducteur.

On entend par température nominale de fonctionnement de la structure semiconductrice, la température maximale à laquelle la structure semiconductrice est destinée à fonctionner en présentant un rapport signal sur bruit nominal. En effet, de telles structures, pour par exemple des applications à la détection d'infrarouges lointains, doivent fonctionner à des températures bien définies, qui sont dans notre exemple aux alentours de 80K, et présente pour des températures supérieures une dégradation de leur sensibilité liée à la chute du rapport signal sur bruit. Selon un autre exemple, une structure semiconductrice destinée à fonctionner à la température ambiante présentera une température nominale de fonctionnement de 80°C, c'est-à-dire 353K.

Cette température nominale de fonctionnement définit une énergie thermique qui correspond à l'énergie cinétique moyenne des molécules à la température nominale. Cette énergie thermique E_{T} est définie par la constante de Boltzmann k avec E_{T}=kT, où T est la température. En reprenant l'exemple d'une structure semiconductrice pour les applications à la détection d'infrarouges lointains, on obtient une énergie thermique d'environ 7 meV.

Une telle première zone d'interface en présentant le long de la première épaisseur d'interface, au moins égale à la moitié de l'épaisseur de barrière, une variation en éléments constitutifs entre une proportion correspondant à celle de la première zone et la proportion barrière, est apte à, lorsque la première zone est polarisée en inverse par rapport à la seconde zone, absorber une partie de la différence de potentiel entre la première et la seconde zone, telle que la déformation de la bande de valence induite par ladite partie supprime la barrière de potentiel pour les porteurs minoritaires créée par la différence de largeur de bande interdite entre la zone barrière et les première et seconde zones. Ainsi, une telle structure ne nécessite pas de dopage particulier de la zone barrière pour que cette dernière ne présente pas de barrière de potentiel au porteur minoritaire lors de la polarisation inverse de la première zone par rapport à deuxième zone.

La seconde zone d'interface, en présentant une faible épaisseur vis-à-vis à la fois de la zone barrière et la première zone d'interface, permet de fournir une barrière de potentiel abrupte pour les porteurs majoritaires avec une déformation réduite de la barrière lors de la polarisation en inverse de la première zone par rapport à la seconde zone. La structure admet avec une telle seconde zone d'interface, une tension de polarisation en inverse de la première zone à partir de laquelle la déformation de la barrière est suffisante pour que les porteurs majoritaires soient susceptibles de passer la barrière, qui est élevée.

Ainsi la structure avec de telles première et seconde zones d'interfaces présente en fonctionnement une barrière de potentiel uniquement pour les porteurs majoritaires qui reste active même pour de fortes polarisations inverses de la structure ceci sans que la zone barrière présente un type de conductivité différent de celui de la première et de la seconde zone.

La structure peut être une structure nBn, c'est-à-dire que la première et la deuxième zone sont du type de conductivité pour lequel les porteurs majoritaires sont des électrons, la zone barrière étant composée des éléments constitutifs et présentant sur toute l'épaisseur de barrière une proportion en éléments constitutifs telle que la zone barrière présente un minimum de largeur de bande interdite supérieure à la largeur de bande interdite de la première zone et qui est telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement.

Ainsi l'invention concerne également une structure semiconductrice du type nBn apte à recevoir un rayonnement électromagnétique et à le transformer en un signal électrique, ladite structure comportant une température nominale de fonctionnement, une telle structure comportant :
- une première et une seconde zone d'un même type de conductivité du type de conductivité pour lequel les porteurs majoritaires sont des électrons, et réalisées respectivement dans un premier et un deuxième matériau semiconducteur, lesdits premier et deuxième matériaux semiconducteurs étant tous deux composés des mêmes éléments, lesdits éléments étant dits constitutifs, une proportion différente en au moins deux de ces éléments constitutifs correspondant à une différence de largeur de bande interdite dudit matériau, le premier matériau étant un matériau semiconducteur à gap direct,
- une zone barrière, disposée entre la première et la seconde zone, destinée à faire office de barrière aux porteurs majoritaires de la première et de la seconde zone sur une épaisseur de barrière, ladite zone barrière étant composée des éléments constitutifs et présentant sur toute l'épaisseur de barrière une proportion en éléments constitutifs telle que la zone barrière présente un minimum de largeur de bande interdite supérieure à la largeur de bande interdite de la première zone et qui est telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement, la proportion en éléments constitutifs pour laquelle la zone barrière présente la largeur de bande interdite la plus faible définissant la proportion barrière,
- une première zone d'interface agencée pour faire interface entre la première zone et la zone barrière sur une première épaisseur d'interface, la première zone d'interface présentant une composition en éléments constitutifs qui est variée, sur toute l'épaisseur d'interface et de la première zone vers la zone barrière, d'une proportion correspondant à celle du premier matériau à la proportion barrière, la première épaisseur d'interface étant au moins égale à la moitié de l'épaisseur de barrière,
et dans laquelle il est prévu une seconde zone d'interface agencée pour faire interface entre la zone barrière et la seconde zone sur une seconde épaisseur d'interface, la seconde zone d'interface présentant une composition en éléments constitutifs qui est variée, sur toute la seconde épaisseur d'interface et de la zone barrière vers la seconde zone , de la proportion barrière à une composition correspondant à celle du second matériau, la seconde épaisseur d'interface étant inférieure à la moitié de l'épaisseur de barrière.

La première épaisseur d'interface peut être égale ou supérieure à l'épaisseur de barrière.

Le premier et le deuxième matériau peuvent présenter des proportions en éléments constitutifs sensiblement identiques.

Les premier et deuxième matériaux présentent ainsi sensiblement la même largeur de bande interdite facilitant le passage des porteurs minoritaires de la première vers la seconde zone.

Selon une application particulière de l'invention les éléments constitutifs sont le cadmium, le mercure et le tellure.

De tels éléments constitutifs sont particulièrement adaptés pour la détection et la mesure à basse température d'un rayonnement électromagnétique dans la gamme des infrarouges, la variation de la proportion de cadmium et de mercure permettant de varier, pour une température de fonctionnement à 80 K, la largeur de la bande interdite d'une valeur allant de 0 eV à plus de 1,6 eV soit, pour une concentration en porteurs majoritaires donnée, une différence entre les bas des bandes de conduction correspondantes d'environ 1,2 eV. De plus, de tels éléments constitutifs permettent également de former des matériaux avec des paramètres de mailles similaires sur toute la plage de variation de la proportion en éléments constitutifs, limitant ainsi l'apparition de défauts d'interface lors de la fabrication d'une telle structure.

La première épaisseur d'interface peut être comprise entre une fois l'épaisseur de barrière et deux fois l'épaisseur de barrière.

Une telle structure présente une épaisseur d'interface suffisamment large pour que, lors de l'application de la polarisation en inverse de la première zone par rapport à la seconde zone, la barrière de potentiel pour les porteurs majoritaires soit annulée même pour une faible polarisation inverse de la première zone par rapport à la seconde zone.

La proportion en éléments constitutifs peut être variée sensiblement régulièrement sur toute la première épaisseur d'interface.

Avec une telle variation de la proportion en éléments constitutifs, la première zone d'interface présente une variation continue de la largeur de bande interdite et donc de l'énergie de la bande d'énergie correspondant aux porteurs minoritaires, cette variation permettant une bonne déformation de la bande de valence.

La proportion en éléments constitutifs peut être variée sensiblement linéairement sur toute la première épaisseur d'interface.

Selon une autre possibilité de l'invention, la proportion en éléments constitutifs peut être variée sensiblement selon une fonction d'erreur, également connue sous la dénomination fonction d'erreur de Gauss, sur toute la première épaisseur d'interface.

Une telle variation de la proportion correspond à un gradient linéaire interdiffusé d'un des éléments constitutifs.

Il peut être prévu une seconde zone d'interface agencée pour faire interface entre la zone barrière et la seconde zone sur une seconde épaisseur d'interface, la seconde zone d'interface présentant une composition en éléments constitutifs qui est variée, sur toute la seconde épaisseur d'interface et de la zone barrière vers la seconde zone, de la proportion barrière à une proportion correspondant à celle du second matériau, la seconde épaisseur d'interface étant inférieure à la moitié de l'épaisseur de barrière.

La seconde épaisseur d'interface peut être inférieure au tiers de l'épaisseur de barrière et préférentiellement inférieure au dixième de l'épaisseur de barrière.

Une telle seconde zone d'interface, en présentant une particulièrement faible épaisseur vis-à-vis à la fois de la zone barrière et la première zone d'interface, permet de fournir une barrière de potentiel abrupte pour les porteurs majoritaires avec une déformation réduite de la barrière lors de la polarisation en inverse de la première zone par rapport à la seconde zone. Ainsi, la structure admet une tension de polarisation en inverse de la première zone à partir de laquelle la déformation de la barrière est suffisante pour que les porteurs majoritaires soient susceptibles de passer la barrière, qui est plus élevée.

L'épaisseur de barrière est comprise entre 100 et 300 nm.

Une telle épaisseur permet à la fois de fournir une barrière de potentiel suffisamment large pour limiter le courant tunnel à travers la barrière et ainsi bloquer le passage des porteurs majoritaires entre la seconde zone et la première zone, tout en étant suffisamment mince pour être rapidement déplétée lors de la polarisation en inverse de la première zone par rapport à la seconde zone.

L'invention se rapporte également à un dispositif semiconducteur, comportant une pluralité de structures semiconductrices, au moins une des structures étant une structure selon l'invention.

Un tel dispositif permet la détection et/ou la mesure d'un rayonnement électromagnétique à basse température avec au moins une des structures qui, étant réalisée dans des matériaux semiconducteurs composés des mêmes éléments constitutifs et ne nécessitant pas un type de dopage de la zone barrière différent de celui de la première et de la seconde zone, ne présente pas, en fonctionnement, de barrière de potentiel pour les porteurs minoritaires.

Il peut être prévu une partie optique et une partie traitement, la partie optique comportant une pluralité de structures semiconductrices, dites optiques, aptes à recevoir un rayonnement électromagnétique et à le transformer en un signal électrique dont au moins une des structures est au moins une structure selon l'invention, la partie traitement comportant des structures semiconductrices agencées entre-elles pour traiter les signaux électriques des structures optiques.

Le placement des structures semiconductrices optiques sur une partie optique du composant et le placement des structures semiconductrices pour le traitement des signaux issus des structures optiques sur une autre partie du composant que la partie optique permettent de combiner sur un même composant les avantages de structures optiques réalisées dans des matériaux semiconducteurs optimisés pour la détection et/ou la mesure du rayonnement électromagnétique à détecter, avec les avantages de structures adaptées pour traiter les signaux électriques des structures semiconductrices optiques réalisées dans un matériau adapté pour de tels traitements comme par exemple le silicium.

L'invention concerne également un procédé de fabrication d'une structure semiconductrice selon l'invention, et comportant les étapes consistant à :
- fournir une première zone d'un premier type de conductivité et réalisée dans un premier matériau semiconducteur, le premier matériau étant composé d'éléments, dits constitutifs, tels, qu'une proportion différente en au moins deux des éléments constitutifs corresponde à une variation de la largeur de bande interdite dudit matériau,
- former une première zone d'interface en contact avec la première zone, la première zone d'interface présentant une première épaisseur d'interface et une composition en éléments constitutifs qui est variée sur toute l'épaisseur d'interface d'une proportion correspondant à celle du premier matériau à une proportion barrière,
- former une zone barrière en contact avec la zone d'interface de manière à ce que la zone d'interface fasse interface entre la première zone et la zone barrière, la zone barrière présentant une épaisseur de barrière au moins inférieure à deux fois la première épaisseur d'interface, la zone barrière étant composée des éléments constitutifs et présentant sur toute l'épaisseur de barrière une proportion telle que la zone barrière possède une largeur de bande interdite supérieure à celle de la première zone, la proportion en éléments constitutifs pour laquelle la zone barrière présente la largeur de bande interdite la plus faible étant égale à la proportion barrière,
- former une seconde zone d'interface sur une seconde épaisseur d'interface, cette seconde zone d'interface étant agencée pour faire interface entre la zone barrière et la seconde zone, la composition en éléments constitutifs de la deuxième zone d'interface étant variée de la proportion barrière à une proportion correspondant à celle du deuxième matériau, la seconde épaisseur d'interface étant inférieure à la moitié de l'épaisseur de barrière, et préférentiellement inférieure à 10 fois l'épaisseur de barrière,
- former une seconde zone du même type de conductivité que la première zone, la seconde zone étant réalisée dans un deuxième matériau semiconducteur composé des éléments constitutifs, la seconde zone étant agencée de manière à ce que la zone barrière soit disposée entre la première et la seconde zone, la largeur de bande interdite de la seconde zone étant telle que la différence entre le bas de la bande de conduction au minimum de largeur de bande interdite de la zone barrière et le bas de la bande de conduction de la seconde zone est égale à au moins 10 fois l'énergie thermique à la température maximum de fonctionnement.

Un tel procédé permet la formation d'une structure apte à recevoir un rayonnement électromagnétique et à le transformer en un signal électrique sans que ladite structure nécessite, pour être fonctionnelle, un type de dopage de la zone barrière différent de celui de la première et de la seconde zone.De plus, un tel procédé permet de fournir une structure avec une barrière de potentiel abrupte pour les porteurs majoritaires et une déformation réduite de la barrière lors de la polarisation en inverse de la première zone par rapport à la seconde zone. Ainsi, une telle structure admet une tension de polarisation en inverse de la première zone à partir de laquelle la déformation de la barrière est suffisante pour que les porteurs majoritaires soient susceptibles de passer la barrière, qui est élevée.

Ainsi, un tel procédé permet la formation d'une structure qui, avec de telles première et seconde zones d'interfaces, présente en fonctionnement une barrière de potentiel uniquement pour les porteurs majoritaires qui reste active même pour de fortes polarisations inverses de la structure ceci sans que la zone barrière présente un type de conductivité différent de celui de la première et de la seconde zone.

Dans l'étape de formation de la seconde zone, la seconde zone peut être réalisée dans un deuxième matériau semiconducteur composé des éléments constitutifs, la seconde zone étant agencée de manière à ce que la zone barrière soit disposée entre la première et la seconde zone, la largeur de bande interdite de la seconde zone étant telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés parmi lesquels :
- la figure 1 illustre un exemple de structure selon l'invention selon une vue schématique en coupe,
- la figure 2 est un graphique représentant la variation de la proportion en cadmium le long de l'axe z de la structure illustrée à la figure 1,
- les figures 3a et 3b sont des diagrammes de bande énergétique de la structure illustrée sur la figure 1, repectivement, lors de l'absence de polarisation et lors d'une polarisation inverse de la première zone par rapport à la seconde zone,
- la figure 4 illustre une vue schématique en coupe d'une partie optique d'un composant semiconducteur selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

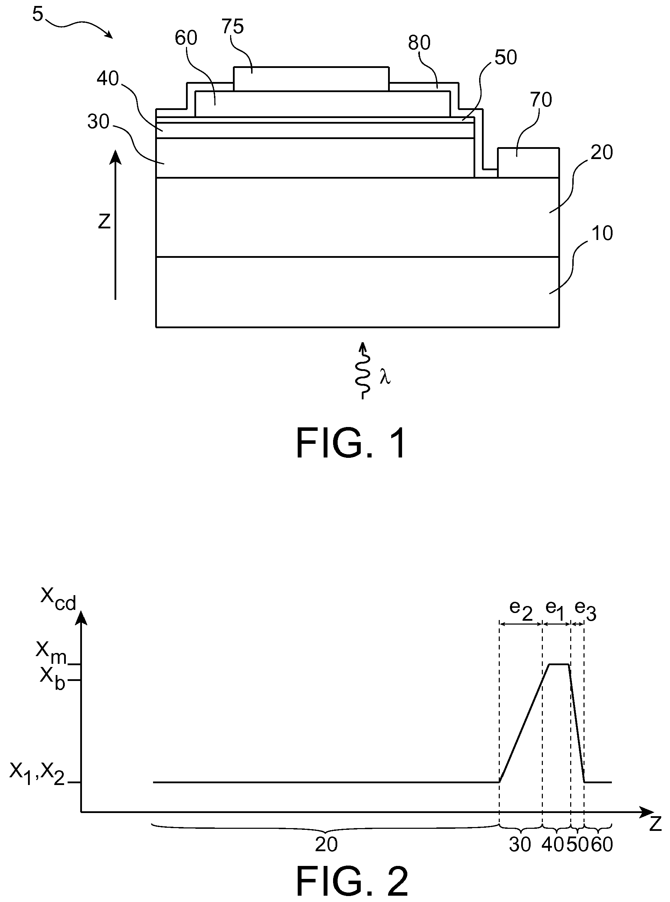

La figure 1 illustre une structure 5 semiconductrice apte à recevoir un rayonnement électromagnétique et à le transformer en un signal électrique. La structure 5 comporte une température de fonctionnement nominale en deçà de laquelle elle présente un rapport signal sur bruit nominal.

Une telle structure 5 peut être adaptée pour détecter et/ou mesurer un rayonnement λ électromagnétique dont la longueur d'onde est comprise dans la gamme des longueurs d'ondes allant des Ultra-violets aux Infrarouges. Les valeurs qui sont indiquées dans la suite de ce document sont adaptées pour une application à la détection et/ou la mesure d'un rayonnement λ infrarouge. De telles valeurs sont fournies à but purement illustratif d'une application particulière de l'invention. Cette application particulière est notée, dans la suite de ce document, application particulière de l'invention.

Une telle structure 5 comporte :
- un support 10 semiconducteur,
- une première zone 20 semiconductrice en contact avec le support 10, la première zone 20 étant pourvue d'un premier contact électrique 70 et étant réalisée dans un premier matériau,
- une première zone d'interface 30 en contact avec la première zone 20, la première zone d'interface 30 présentant une première épaisseur d'interface e₂,
- une zone barrière 40 en contact avec la première zone d'interface 30, la zone barrière 40 présentant une épaisseur de barrière e₁,
- une seconde zone d'interface 50 en contact avec la zone barrière 40, la seconde zone d'interface 50 présentant une seconde épaisseur d'interface e₃,
- une seconde zone 60 semiconductrice en contact avec la seconde zone d'interface 50, la seconde zone 60 étant pourvue d'un second contact électrique 75 et étant réalisée dans un deuxième matériau, et
- une couche de passivation de surface 80 adaptée pour passiver la surface de la structure 5 autre que le premier et second contact électrique 70, 75, ladite couche de passivation ayant également fonction d'isolation électrique.

La première zone 20, la première zone d'interface 30, la zone barrière 40, la seconde zone d'interface 50 et la seconde zone 60 sont réalisées à partir des mêmes éléments, dits constitutifs.

Les éléments constitutifs sont sélectionnés de manière à ce que deux matériaux semiconducteurs, comportant une proportion différente en au moins deux des éléments constitutifs, présentent une largeur de bande interdite différente. La plage sur laquelle la largeur de bande interdite peut être variée doit être telle que la différence de largeur de bande interdite entre un matériau comportant la proportion en éléments constitutifs fournissant la plus faible largeur de bande interdite et un matériau comportant la proportion en éléments constitutifs fournissant la plus grande largeur de bande interdite soit adaptée pour la formation d'une barrière de potentiel pour au moins un type de conductivité.

Une telle condition est remplie, par exemple, avec des éléments constitutifs dont la différence énergétique entre le bas de la bande de conduction pour respectivement le minimum et le maximum de largeur de bande interdite qui peuvent être obtenus en variant la proportion en éléments constitutifs, est au moins égale à au moins 10 fois l'énergie thermique à la température maximum de fonctionnement (ceci pour des porteurs majoritaires qui sont des électrons et une concentration en porteur majoritaire identique dans les première et seconde zones, ainsi que dans la zone barrière). Les éléments constitutifs sont le cadmium Cd, le mercure Hg et le tellure Te avec des matériaux dont la composition est du type Cd_{X}Hg_{1-X}Te. De tels éléments constitutifs permettent de répondre à cette dernière condition. En effet, pour une température de fonctionnement nominale de 80 K, deux matériaux du type Cd_{X}Hg_{1-X}Te, possédant une proportion X de cadmium de respectivement 0,18 et 1, la différence est d'environ 1,2 eV. L'énergie thermique étant à 80K d'environ 7 meV, la différence qui peut être obtenue est bien supérieure à 10 fois l'énergie thermique, c'est-à-dire environ 70 meV.

Ceci est également valable pour des températures plus hautes. Ainsi à la température ambiante, l'énergie thermique est d'environ 26 meV, soit une différence qui doit être supérieure à 260 meV. Cette valeur est également accessible avec les éléments constitutifs que sont le cadmium Cd, le mercure Hg et le tellure Te.

On entend par la suite, pour l'application particulière de l'invention, par proportion en éléments constitutifs, la proportion en cadmium, cette dernière donnant directement la proportion en mercure et en tellure, les matériaux constituant une structure selon l'application particulière selon l'invention étant du type Cd_{X}Hg_{1-X}Te, X étant la proportion en cadmium.

Le support 10 semiconducteur est en matériau semiconducteur adapté pour la croissance du matériau formant la première zone 20. Ainsi, pour l'application particulière de l'invention pour laquelle les éléments constitutifs sont le cadmium Cd, le mercure Hg et le tellure Te, le support semiconducteur est, par exemple, du tellure de cadmium et de zinc (CdZnTe).

Le support 10 semiconducteur est, comme illustré sur la figure 1, un support sensiblement plat présentant une première et une seconde face.

La première zone 20 est en contact avec la seconde face du support 10. La première zone 20 est une couche sensiblement plane dont une face est en contact avec le support 10.

La première zone 20 est réalisée dans le premier matériau. Le premier matériau est composé des éléments constitutifs. Le premier matériau est un matériau semiconducteur à gap direct. La largeur de bande interdite du premier matériau est adaptée à la longueur d'onde du rayonnement λ électromagnétique à détecter et/ou mesurer. Cette adaptation de la largeur de bande interdite du premier matériau est obtenue par une proportion en éléments constitutifs X₁ adaptée pour que la largeur de bande interdite du premier matériau corresponde à une énergie inférieure à celle du rayonnement λ électromagnétique à détecter.

Le premier matériau présente un premier type de conductivité avec des porteurs majoritaires et des porteurs minoritaires. Par la suite, on entend par porteurs majoritaires et par porteurs minoritaires, les porteurs qui sont respectivement majoritaires et minoritaires dans le premier matériau.

Le premier contact électrique 70 est un contact électrique adapté au premier matériau et au type de conductivité qu'il présente.

Selon l'application particulière de l'invention, le premier matériau peut comporter, pour une structure adaptée pour la détection et/ou la mesure d'un rayonnement λ électromagnétique dans la gamme des infrarouges moyens inférieurs à 3 µm, une proportion en éléments constitutifs X₁ égale à 0,4, et pour la détection et/ou la mesure d'un rayonnement λ électromagnétique dans la gamme des infrarouges moyens inférieurs à 5 µm, une proportion en éléments constitutifs X₁ égale à 0,3. Pour une détection et/ou mesure d'un rayonnement λ électromagnétique dans la gamme des infrarouges lointains inférieurs à 10 µm, la proportion en éléments constitutifs X₁ du premier matériau est égale à 0,22.

Selon cette même application particulière, le premier matériau présente une conductivité telle que les porteurs majoritaires de la première zone 20 sont des électrons, les porteurs minoritaires étant donc des trous h⁺. Un tel type de conductivité est obtenu par un dopage du premier matériau à partir d'éléments constitutifs dopants apportant un excédent d'électrons, tels que de l'indium (In). La concentration en porteurs majoritaires est comprise entre 5.10¹⁴ et 5.10¹⁵ cm⁻³.

Selon l'application particulière de l'invention, le premier contact électrique 70 est un contact en or, un tel contact étant adapté pour contacter électriquement un matériau du type Cd_{X}Hg_{1-X}Te.

La première zone 20, étant la zone de la structure adaptée pour absorber le rayonnement λ électromagnétique, présente une épaisseur adaptée pour une telle absorption. Ainsi, pour l'application particulière de l'invention, l'épaisseur de la première zone 20 est au moins égale à 2 µm et est préférentiellement de l'ordre de la longueur d'onde pour laquelle la structure est adaptée.

On entend ci-dessus et dans le reste de ce document, par épaisseur d'une zone de la structure, la dimension de la zone selon un axe s'étendant de la première zone en direction de la seconde zone. Un tel axe est, selon le mode de réalisation illustré sur la figure 1 et pour chacune des zones, sensiblement perpendiculaire à une surface d'interface avec une autre zone avec laquelle la zone est en contact. Cet axe est, pour le mode réalisation décrit dans ce document, l'axe z représenté sur la figure 1.

La première zone 20 présente une face en contact avec le support 10 et une face opposée au support 10.

La première zone d'interface 30 est en contact avec la première zone 20 sur la face de la première zone opposée au support 10. La première zone d'interface 30 est une couche sensiblement plane en contact avec la première zone 20 au niveau de la face de la première zone 20 qui est opposée au support 10.

La première zone d'interface 30 présente une composition en éléments constitutifs qui est variée de la première zone 20 vers la zone barrière 40, sur toute la première épaisseur d'interface e₂ et de la première zone 20 vers la zone barrière 40, d'une proportion correspondant à celle du premier matériau X₁ à une proportion barrière X_{b}.

La proportion en éléments constitutifs dans la première zone d'interface 30 est variée sensiblement régulièrement sur toute la première épaisseur d'interface e₂. La proportion en éléments constitutifs dans la première zone d'interface 30 est variée, comme illustré sur la figure 2, sensiblement linéairement sur toute la première épaisseur d'interface e₂.

La première zone d'interface 30 présente une face en contact avec la première zone 20 et une face, qui étant opposée à la face en contact avec la première zone 20, est en contact avec la zone barrière 40.

La zone barrière 40 est une zone de la structure 5 qui est destinée à faire office de barrière aux porteurs majoritaires de la première et de la seconde zone 20, 60. La zone barrière 40 est une couche sensiblement plane.

L'épaisseur de barrière e₁ est l'épaisseur pour laquelle la zone barrière 40 présente une largeur de bande interdite telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement.

L'épaisseur de barrière e₁ présente une dimension suffisamment large pour que la zone barrière fasse office de barrière aux porteurs majoritaires et bloque le passage des porteurs majoritaires entre la seconde zone 60 et la première zone 10. L'épaisseur de barrière e₁ est également suffisamment faible pour autoriser une déplétion rapide de la zone barrière lors d'une polarisation en inverse de la première zone 20 par rapport à la seconde zone 60.

La proportion barrière X_{b} est la proportion en éléments constitutifs nécessaire pour que la largeur de bande interdite d'un matériau comportant la proportion barrière X_{b} telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement.

La proportion en éléments constitutifs dans la zone barrière varie, comme illustré sur la figure 2, entre la proportion barrière X_{b} et une proportion de largeur maximum Xₘ. La proportion de largeur maximum Xₘ est la proportion en éléments constitutifs pour laquelle la zone barrière 40 présente une largeur de bande interdite maximum.

Selon l'application particulière de l'invention, la proportion barrière X_{b} et la proportion de largeur maximum Xₘ sont respectivement égales à 0,8 et à 0,85, pour une structure adaptée pour la détection d'un rayonnement λ électromagnétique dans la gamme des infrarouges moyens inférieurs à 3 µm (X1=0,4), et à 0,6 et à 0,65 pour la détection d'un rayonnement λ électromagnétique dans la gamme des infrarouges moyens inférieurs à 5 µm (X1=0,3). Pour une détection dans la gamme des infrarouges lointains inférieurs à 10 µm (X1=0,22), la proportion barrière X_{b} et la proportion de largeur maximum Xₘ sont respectivement égale à 0.55 et à 0,6. Les températures nominales de fonctionnement pour des structures selon ces applications particulières étant respectivement de 80 K, 120 K et 170 K pour la détection dans la gamme du proche infrarouge, de l'infrarouge moyen et l'infrarouge lointain, le critère à 10 fois kT est largement respecté dans chacune de ces configurations, et ce même pour des températures plus élevées (proche de la température ambiante).

La zone barrière 40 présente le long de l'épaisseur de barrière e₁, et à partir de la première zone d'interface 30 et direction de la seconde zone barrière 50, successivement :
- une première partie le long de laquelle la proportion en éléments constitutifs est variée linéairement de la proportion barrière X_{b} à la proportion de largeur maximum Xₘ,
- une deuxième partie le long de laquelle la proportion en éléments constitutifs est sensiblement constante et égale à la proportion de largeur maximum Xₘ,
- une troisième et dernière partie le long de laquelle la proportion en éléments constitutifs est variée linéairement de la proportion de largeur maximum Xₘ à la proportion barrière X_{b}.

De manière à présenter une barrière de potentiel efficace, la deuxième partie représente la majeure partie de la zone barrière 40.

Selon l'application particulière de l'invention, l'épaisseur de barrière e₁ est comprise entre 100 et 300 nm, préférentiellement égale à 300 nm.

La zone barrière 40 présente une face en contact avec la première zone d'interface 30 et une face qui, étant opposée à la face en contact avec la zone d'interface 30, est en contact avec la seconde zone d'interface 50.

La seconde zone d'interface 50 est une couche sensiblement plane en contact avec la zone barrière 40 au niveau de la face de la zone barrière 40 qui est opposée à la première zone d'interface 30.

La seconde zone d'interface 50 présente une composition en éléments constitutifs qui est variée sur toute la seconde épaisseur d'interface e₃ et de la zone barrière 40 vers la seconde zone, d'une proportion correspondant à celle de la proportion barrière X_{b} à une proportion correspondant à un deuxième matériau X₂.

La proportion en éléments constitutifs dans la seconde zone d'interface 50 est variée sensiblement régulièrement sur toute la seconde épaisseur d'interface e₃. La proportion en éléments constitutifs dans la seconde zone d'interface 50 est variée, comme illustré sur la figure 2, sensiblement régulièrement sur toute la seconde épaisseur d'interface e₃.

La seconde épaisseur d'interface e₃ est la plus faible possible et est inférieure au tiers de l'épaisseur de barrière e₁ et préférentiellement inférieure à un dixième de l'épaisseur de barrière e₁.

Selon l'application particulière, de l'invention, l'épaisseur de barrière e₁ est inférieure à 30 nm.

La seconde zone d'interface 50 présente une face en contact avec la zone barrière 40 et une face qui, étant opposée à la face en contact avec la zone barrière, est en contact avec la seconde zone 60.

La seconde zone 60 est une couche sensiblement plane en contact avec la seconde zone d'interface 50 au niveau de la face de la seconde zone d'interface 50 qui est opposée à la zone barrière 40.

La seconde zone 60 est réalisée dans le deuxième matériau dont la proportion en éléments constitutifs X₂ est, comme illustré sur la figure 2, sensiblement identique à la proportion en éléments constitutifs X₁ du premier matériau.

Le deuxième matériau présente un type de conductivité et une concentration en porteurs majoritaires sensiblement identiques au premier matériau.

La seconde zone 60 est pourvue du second contact électrique 75 adapté pour permettre une polarisation de la seconde zone 50 et donc adapté pour le deuxième matériau.

Selon l'application particulière de l'invention le second contact électrique 75 est un contact en titane et/ou or, un tel contact étant adapté pour un matériau du type Hg_{X}Cd_{1-X}Te.

La structure 5 est pourvue d'une couche de passivation de surface 80 sur les surfaces de la structure 5 autres que le premier et le second contact électrique 70, 75, cette couche de passivation de surface 18 ayant également une fonction d'isolation électrique des surfaces de la structure 5.

Selon l'application particulière la passivation de surface 80 est réalisée en tellurure de cadmium CdTe ou en sulfure de zinc ZnS.

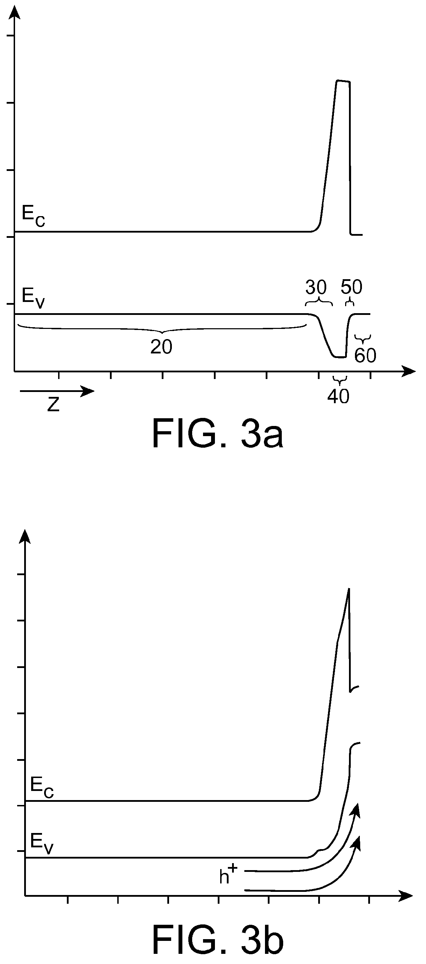

Une telle structure 5, lorsqu'elle est une structure selon l'application particulière de l'invention, présente sans polarisation une structure de bande telle qu'illustrée sur la figure 3a.

La première zone présente une largeur de bande interdite constante sur toute son épaisseur, dont la largeur de bande interdite est légèrement inférieure à l'énergie du rayonnement λ électromagnétique à détecter et/ou mesurer.

La première zone d'interface 30, en raison de la variation de la proportion d'éléments constitutifs le long de la première épaisseur d'interface e₂, présente une largeur de bande interdite qui augmente sur toute la première épaisseur d'interface e₂. Les éléments constitutifs étant le mercure, le cadmium et le tellure, l'élargissement de la largeur de bande interdite, lié à l'augmentation de la proportion de cadmium, est asymétrique, prés de 20% de l'augmentation étant répartie sur la bande de valence et prés de 80% de l'augmentation étant répartie sur la bande de conduction.

Dans la zone barrière, la largeur de la bande interdite augmente rapidement pour atteindre une largeur de bande interdite maximum. La largeur de bande interdite maximum étant atteinte, la zone barrière 40 présente sur la majeure partie de l'épaisseur de barrière e₁ une largeur de bande interdite sensiblement constante.

La structure de bande de la zone barrière, correspondant principalement à un décalage de la bande de conduction Ec vers les hautes énergies par rapport à la première et la seconde zone, il y a formation d'une barrière de potentiel pour les électrons qui sont les porteurs majoritaires. La structure de bande présente également un décalage de bande de valence Ev vers les basses énergies par rapport à la première et la seconde zone, il y a donc également formation d'une barrière de potentiel pour les trous qui sont les porteurs minoritaires. La zone barrière présente ainsi, et en raison de l'asymétrie de décalage pour les bandes de conduction et de valence, une forte et faible barrière de potentiel pour respectivement les électrons et les trous.

Sur la fin de l'épaisseur de barrière, la largeur de bande interdite est réduite pour atteindre la valeur de bande interdite correspondant à un matériau possédant la proportion barrière X_{b}.

Dans la seconde zone d'interface 50, la variation de la proportion en éléments constitutifs le long de la seconde épaisseur d'interface e₃ entraîne une diminution de la largeur de bande interdite sur toute la seconde épaisseur d'interface e₃. En raison de l'adaptation de la seconde épaisseur d'interface e₃, la variation de la largeur de bande interdite est abrupte par rapport à la variation dans la première zone d'interface 30.

La seconde zone d'interface 50 présente une largeur de bande interdite sensiblement identique à celle de la première zone 20, ceci pour faciliter en fonctionnement le passage des porteurs minoritaires de la première vers la seconde zone 20,60.

Lors de la mise en oeuvre d'une structure 5 selon l'invention, la première zone 20 est polarisée en inverse par rapport à la seconde zone 60, cette polarisation étant réalisée aux moyens du premier et du second contact électrique 70, 75. Une telle structure 5, en présentant lors de cette polarisation une structure de bande du même type que celle illustrée sur la figure 3b, est apte à la détection d'un rayonnement λ électromagnétique. En effet, pour toute paire électron-trou générée dans la première zone 20, le porteur minoritaire de la paire est accéléré par la différence de potentiel appliquée entre la première et la seconde zone 20, 60 et est directement collecté par le champ électrique se développant dans la barrière 40 et son interface 30. En effet, le porteur majoritaire ne rencontre pas de barrière de potentiel lors du passage de la zone barrière.

La figure 3b, concernant une structure 5 selon l'application particulière de l'invention permet de mieux comprendre le fonctionnement.

Pour une telle structure 5, la tension appliquée pour permettre la mesure et/ou la détection d'un rayonnement λ électromagnétique infrarouge doit être de l'ordre de quelques centaines de millivolts. On peut observer sur la figure 3b que lors de la polarisation en inverse de la première zone vis-à-vis de la seconde zone, la variation de potentiel est principalement reportée dans la première zone d'interface 30 et la zone barrière 40.

Il en résulte donc, dans la première zone d'interface 30 et dans la zone barrière 40, une remontée des bandes de valence et de conduction vers les hautes énergies. Cette remontée, pour la première zone d'interface 30 et à partir d'une tension seuil de fonctionnement, déforme la bande de valence suffisamment pour supprimer la barrière de potentiel pour les porteurs minoritaires. La déformation des bandes de conduction et de valence au niveau de la seconde zone d'interface 50 restant réduite, la zone barrière continue à former une barrière de potentiel empêchant tout courant de porteurs majoritaires entre la seconde zone 60 et la première zone 20.

Ainsi, en l'absence de rayonnement λ électromagnétique, aucun courant de porteurs majoritaires ne transite au travers de la structure 5. Lors de l'exposition de la structure 5 à un rayonnement λ électromagnétique d'énergie suffisante, une paire électron-trou étant générée dans la première zone 20 par un photon, le trou de la paire est accéléré et passe, sans rencontrer de barrière de potentiel, dans la seconde zone 60 dans laquelle il est collecté. Le courant ainsi généré, avec une électronique adaptée, permet la détection et/ou la mesure du rayonnement λ électromagnétique.

Une structure 5 selon l'application particulière peut être réalisée selon un procédé de fabrication comportant les étapes consistant à :
- fournir un support 10 semiconducteur de tellure de cadmium et de zinc (CdZnTe),
- déposer sur le support 10 les éléments constitutifs de manière à former une couche du premier matériau formant la première zone 20,
- déposer sur la première zone 20 les éléments constitutifs de manière à former la première zone d'interface 30, les éléments constitutifs étant déposés sous forme de couche et avec une composition en éléments constitutifs qui est variée de la proportion X₁ correspondant au premier matériau à la proportion barrière X_{b} ceci sur la première épaisseur d'interface e₁,
- déposer sur la première zone d'interface 30 les éléments constitutifs de manière à former la zone barrière 40, les éléments constitutifs étant déposés sous la forme d'une couche dont l'épaisseur est l'épaisseur de barrière e₁, la proportion en éléments constitutifs dans la zone barrière 40 étant comprise entre la proportion barrière X_{b} et la proportion de largeur maximum Xₘ,
- déposer sur la zone barrière 40 les éléments constitutifs de manière à former la seconde zone d'interface 50, les éléments constitutifs étant déposés pour former une couche et avec une proportion en éléments constitutifs qui est variée de la proportion barrière X_{b} à la proportion correspondant à la seconde zone X₂ ceci sur la seconde épaisseur d'interface e₃,
- déposer sur la seconde zone d'interface 50 les éléments constitutifs de manière à former une couche du deuxième matériau formant la seconde zone 60,
- former le premier et le deuxième contact électrique 70, 75 sur respectivement la première et la seconde zone 60,
- déposer la passivation de surface 80 sur les surfaces de la structure autres que les contacts métalliques 70, 75.

Pour l'application particulière de l'invention, les étapes consistant à déposer les éléments constitutifs peuvent être réalisées par un dépôt par épitaxie par jet moléculaire ou par épitaxie en phase vapeur aux organométalliques.

On peut également noter que de façon à définir le type de conductivité et la concentration en porteurs majoritaires dans les zones 10, 20, 30, 40, 50, 60 de la structure, des éléments dopants sont déposés concomitamment au dépôt des éléments constitutifs lors de la formation des différentes zones 10, 20, 30, 40, 50, 60. Selon le type d'éléments dopants, le procédé de fabrication de la structure 5 peut comporter une étape d'activation des éléments dopants, telle que par exemple une étape de recuit thermique.

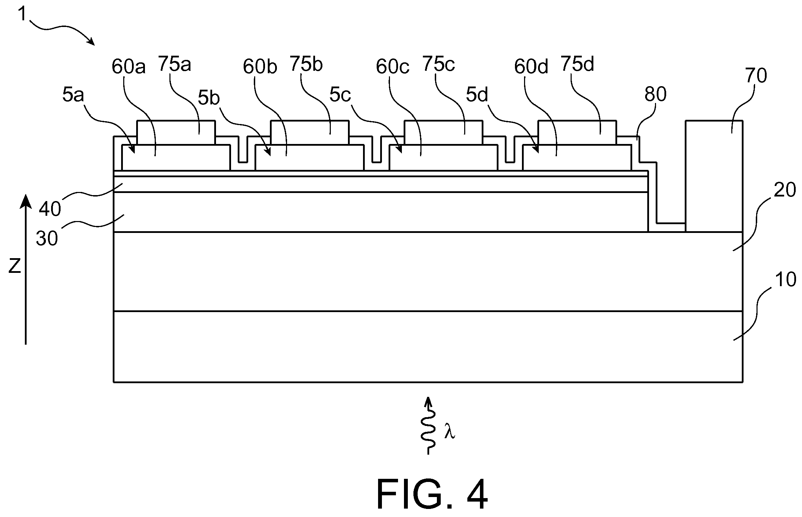

L'invention concerne également un dispositif 1, tel que celui illustré en partie sur la figure 4, comportant des structures 5a, 5b, 5c, 5d selon l'invention.

Un tel dispositif 1 comporte une première partie 2, dite optique, et une seconde partie, dite de traitement, non illustrée.

La partie optique 2, illustrée sur la figure 4, présente quatre structures 5a, 5b, 5c, 5d selon l'invention.

La partie optique 2 comprend :
- un support 10 semiconducteur commun à l'ensemble des structures 5a, 5b, 5c, 5d,
- une première zone 20 semiconductrice en contact avec le support semiconducteur 10, la première zone présentant un premier contact électrique 70 et étant réalisée dans le premier matériau, ladite première zone 20 étant commune à l'ensemble des structures 5a, 5b, 5c, 5d,
- une première zone d'interface 30 en contact avec la première zone 20, ladite première zone d'interface 30 étant commune à l'ensemble des structures 5a, 5b, 5c, 5d,
- une zone barrière 40 en contact avec la première zone d'interface 30, la zone barrière 40 étant commune à l'ensemble des structures 5a, 5b, 5c, 5d,
- une seconde zone d'interface 50 en contact avec la zone barrière 40, la seconde zone d'interface 50 étant commune à l'ensemble des structures 5a, 5b, 5c, 5d,
- une seconde zone 60a, 60b, 60c, 60d semiconductrice par structure en contact avec la seconde zone d'interface 50, chaque seconde zone 60a, 60b, 60c, 60d présentant un second contact électrique 75a, 75b, 75c, 75d et étant réalisée dans un deuxième matériau, et
- une couche de passivation de surface 80 adaptée pour passiver la surface de la partie optique 2 autre que le premier et les seconds contacts électriques 70, 75a, 75b, 75c et 75d.

Les structures 5a, 5b, 5c, 5d de la partie optique 2 utilisant un principe de fonctionnement identique à la structure 5 décrite précédemment, les différentes zones 10, 20, 30, 40, 50, 60a,b,c,d de la partie optique 2 présentent des caractéristiques identiques à celles de la structure précédemment décrite.

Pour permettre une hybridation à l'indium de la partie optique 2 sur la partie de traitement du dispositif, l'ensemble des contacts électriques de la partie optique 2 sont agencés de manière à définir un plan d'hybridation adapté pour permettre une connexion par hybridation à l'indium, de la partie optique à la partie traitement, ceci afin de former le dispositif.

La partie de traitement est une partie comportant des structures semiconductrices interconnectées ensemble pour former des circuits de traitement adaptés pour traiter les signaux électriques des structures optiques 5a, 5b, 5c, 5d. Une telle partie de traitement utilise des structures de type transistor et est réalisée en silicium. La partie traitement comporte également des contacts électriques adaptés pour permettre la connexion à la partie optique par hybridation à l'indium. Ainsi, un tel dispositif permet de combiner les avantages de l'utilisation d'un matériau semiconducteur optique, tel que le Cd_{X}Hg_{1-X}Te à ceux du traitement par une électronique faible bruit et rapide fournie par les structures silicium.

La mise en oeuvre d'un tel dispositif 1, pour sa partie optique est similaire à celle de la structure selon l'invention.

Le procédé de fabrication d'un tel dispositif 1 est similaire à celui d'une structure 5 selon l'invention si ce n'est la mise en oeuvre d'étapes de masquage liées à la réalisation des secondes zones 60a,b,c,d et leur second contact électrique qui sont propres à chacune des structures optiques 5a,b,c,d.

Si, dans le mode de réalisation décrit ci-dessus, une structure 5 selon l'invention présente une zone barrière 40 comportant trois parties avec, la deuxième partie qui, représentant la majeur partie de la zone barrière, possède une proportion en éléments sensiblement constante, la zone barrière 40 peut comporter une variation quelconque de proportion en éléments constitutifs sur une majeure partie de l'épaisseur de barrière e₁, ceci sans que l'on sorte du cadre de l'invention. Selon cette possibilité, la variation de la proportion en éléments constitutifs le long de l'épaisseur de barrière e₁ doit être telle que la largeur de bande interdite sur toute la zone barrière 40 est égale ou supérieure à la largeur de bande interdite correspondant à la proportion barrière X_{b}.

Si dans le mode de réalisation décrit ci-dessus une structure 5 selon l'invention présente une proportion en éléments constitutifs X₂ dans le second matériau sensiblement identique à la proportion en éléments constitutifs X₁ dans le premier matériau, la proportion en éléments constitutifs X₂ dans le second matériau peut être différente de celle du premier matériau sans que l'on sorte du cadre de l'invention.

Dans l'application particulière de l'invention, les porteurs majoritaires sont des électrons et la structure est une structure du type nBn (n pour le type de dopage de la première et de la seconde zone et B pour barrière). Une structure selon l'invention peut également, sans que l'on sorte du cadre de l'invention, présenter un type de conductivité pour laquelle les porteurs majoritaires sont des trous, la structure étant, selon cette possibilité, une structure du type pBp (p pour le type de dopage de la première et de la seconde zone et B pour barrière).

De même, si dans le mode de réalisation décrit dans ce document, la première et la seconde zone d'interface présentent chacune une variation de la proportion en éléments constitutifs le long de leur épaisseur respective qui est linéaire, la variation de proportion en éléments d'au moins une de la première et de la seconde zone peut présenter une variation autre que linéaire sans que l'on sorte du cadre de l'invention.

Si dans le mode de réalisation décrit dans ce document, la proportion en éléments constitutifs est variée linéairement dans la première et la seconde zone d'interface, il est envisageable, sans que l'on sorte du cadre de l'invention, que la proportion en éléments constitutifs de l'une ou des deux zones d'interface soit variée autrement que linéairement. Ainsi, il est également envisageable que pour l'une ou les deux zones d'interface la proportion en éléments constitutifs soit variée selon une fonction d'erreur, également connue sous la dénomination fonction d'erreur de Gauss.

## Revendications

1. Structure (5) semiconductrice apte à recevoir un rayonnement (λ) électromagnétique et à le transformer en un signal électrique, ladite structure comportant une température nominale de fonctionnement, une telle structure (5) comportant :
- une première et une seconde zone (20, 60) d'un même type de conductivité et réalisées respectivement dans un premier et un deuxième matériau semiconducteur, lesdits premier et deuxième matériaux semiconducteurs étant tous deux composés des mêmes éléments, lesdits éléments étant dits constitutifs, une proportion différente en au moins deux de ces éléments constitutifs correspondant à une différence de largeur de bande interdite dudit matériau, le premier matériau étant un matériau semiconducteur à gap direct,
- une zone barrière (40), disposée entre la première et la seconde zone (20, 60), destinée à faire office de barrière aux porteurs majoritaires de la première et de la seconde zone (20, 60) sur une épaisseur de barrière (e₁), ladite zone barrière (40) étant composée des éléments constitutifs et présentant sur toute l'épaisseur de barrière (e₁) une proportion en éléments constitutifs telle que la zone barrière (40) présente un minimum de largeur de bande interdite supérieure à la largeur de bande interdite de la première zone (20) et qui est telle que la différence en valeur absolue entre l'énergie de l'extremum de bande d'énergie correspondant au porteur majoritaire pour le minimum de largeur de bande interdite de la zone barrière et l'énergie de ce même extremum de la seconde zone est égale à au moins 10 fois l'énergie thermique à la température nominale de fonctionnement, la proportion en éléments constitutifs pour laquelle la zone barrière (40) présente la largeur de bande interdite la plus faible définissant la proportion barrière (X_{b}),
la structure (5) **étant caractérisée en ce qu**'elle comporte une première zone d'interface (30) agencée pour faire interface entre la première zone (20) et la zone barrière (40) sur une première épaisseur d'interface (e₂), la première zone d'interface présentant une composition en éléments constitutifs qui est variée, sur toute l'épaisseur d'interface (e₂) et de la première zone (20) vers la zone barrière (40), d'une proportion correspondant à celle du premier matériau à la proportion barrière (X_{b}), la première épaisseur d'interface (e₂) étant au moins égale à la moitié de l'épaisseur de barrière (e₁) **et dans laquelle** il est prévu une seconde zone d'interface (50) agencée pour faire interface entre la zone barrière (40) et la seconde zone (60) sur une seconde épaisseur d'interface (e₃), la seconde zone d'interface (50) présentant une composition en éléments constitutifs qui est variée, sur toute la seconde épaisseur d'interface (e₃) et de la zone barrière (40) vers la seconde zone (60), de la proportion barrière (X_{b}) à une composition correspondant à celle du second matériau (X₂), la seconde épaisseur d'interface (e₃) étant inférieure à la moitié de l'épaisseur de barrière (e₁).

2. Structure (5) selon la revendication 1, dans laquelle la structure est une structure nBn, c'est-à-dire que la première et la deuxième zone sont du type de conductivité pour lequel les porteurs majoritaires sont des électrons, la zone barrière (40) étant composée des éléments constitutifs et présentant sur toute l'épaisseur de barrière (e₁) une proportion en éléments constitutifs telle que la zone barrière (40) présente un minimum de largeur de bande interdite supérieure à la largeur de bande interdite de la première zone (20) et qui est telle que la différence en valeur absolue entre l'énergie de l'extremum de bande d'énergie correspondant au porteur majoritaire pour le minimum de largeur de bande interdite de la zone barrière et l'énergie de ce même extremum de la bande de conduction de la seconde zone est égale à au moins 10 fois l'énergie thermique à la température nominale de fonctionnement.

3. Structure (5) selon la revendication 1 ou 2, dans laquelle le premier et le deuxième matériau présentent des proportions en éléments constitutifs sensiblement identiques.

4. Structure (5) selon l'une quelconque des revendications précédentes, dans laquelle les éléments constitutifs sont le cadmium (Cd), le mercure (Hg) et le tellure (Te).

5. Structure (5) selon l'une quelconque des précédentes revendications, dans laquelle la première épaisseur d'interface (e₂) est comprise entre une fois l'épaisseur de barrière (e₁) et deux fois l'épaisseur de barrière (e₁).

6. Structure (5) selon l'une quelconque des précédentes revendications, dans laquelle la proportion en éléments constitutifs est variée sensiblement régulièrement sur toute la première épaisseur d'interface (e₂).

7. Structure (5) selon l'une quelconque des revendications précédentes, dans laquelle la seconde épaisseur d'interface (e₃) est inférieure au tiers de l'épaisseur de barrière (e₁) et préférentiellement inférieure au dixième de l'épaisseur de barrière (e₁).

8. Structure (5) selon l'une quelconque des revendications précédentes, dans laquelle l'épaisseur de barrière (e₁) est comprise entre 100 et 300 nm.

9. Dispositif (1) semiconducteur, comportant une pluralité de structures (5a,b,c,d) semiconductrices, **caractérisé en ce qu'**au moins une des structures (5a,b,c,d) est une structure selon l'une quelconque des précédentes revendications.

10. Dispositif (1) semiconducteur selon la revendication 9, dans lequelle il est prévu une partie optique (2) et une partie traitement, la partie optique (2) comportant une pluralité de structures (5a,b,c,d) semiconductrices, dite optiques, aptes à recevoir un rayonnement (λ) électromagnétique et à le transformer en un signal électrique dont au moins une des structures (5a,b,c,d) étant au moins une structure selon l'une des renvendication 1 à 8, la partie traitement comportant des structures semiconductrices agencées entre-elles pour traiter les signaux électriques des structures (5a,b,c,d) optiques.

11. Procédé de fabrication d'une structure (5) semiconductrice selon l'une des revendications 1 à 8, comportant les étapes consistant à :
- fournir une première zone (20) d'un premier type de conductivité et réalisée dans un premier matériau semiconducteur, le premier matériau étant composé d'éléments, dits constitutifs, tels, qu'une proportion différente en au moins deux des éléments constitutifs corresponde à une variation de la largeur de bande interdite dudit matériau,
- former une première zone d'interface (30) en contact avec la première zone (20), la première zone d'interface (30) présentant une première épaisseur d'interface (e₂) et une composition en éléments constitutifs qui est variée sur toute l'épaisseur d'interface (e₂) d'une proportion correspondant à celle du premier matériau à une proportion barrière,
- former une zone barrière (40) en contact avec la zone d'interface (30) de manière à ce que la zone d'interface (40) fasse interface entre la première zone (20) et la zone barrière (40), la zone barrière (40) présentant une épaisseur de barrière (e₁) au moins inférieure à deux fois la première épaisseur d'interface (e₂), la zone barrière (40) étant composée des éléments constitutifs et présentant sur toute l'épaisseur de barrière (e₁) une proportion telle que la zone barrière (40) possède une largeur de bande interdite supérieure à celle de la première zone (20), la proportion en éléments constitutifs pour laquelle la zone barrière (40) présente la largeur de bande interdite la plus faible étant égale à la proportion barrière (X_{b}),
- former une seconde zone d'interface (50) sur une seconde épaisseur d'interface (e₃), la composition en éléments constitutifs de la deuxième zone d'interface étant variée de la proportion barrière (X_{b}) à une proportion correspondant à celle du deuxième matériau, la seconde épaisseur d'interface (e₃) étant inférieure à la moitié de l'épaisseur de barrière (e₁),
- former une seconde zone (60) du même type de conductivité que la première zone (20), la seconde zone (20) étant réalisée dans un deuxième matériau semiconducteur composé des éléments constitutifs, la seconde zone (60) étant agencée de manière à ce que la zone barrière (40) soit disposée entre la première et la seconde zone (20, 60), la largeur de bande interdite de la seconde zone (60) étant telle que la différence en valeur absolue entre l'énergie de l'extremum de bande d'énergie correspondant au porteur majoritaire pour le minimum de largeur de bande interdite de la zone barrière et l'énergie de ce même extremum de la seconde zone est égale à au moins 10 fois l'énergie thermique à la température nominale de fonctionnement.

## Patentansprüche

1. Halbleiterstruktur (5), die dazu ausgelegt ist, eine elektromagnetische Strahlung (λ) zu empfangen und sie in ein elektrisches Signal umzuwandeln, wobei die Struktur eine nominale Arbeitstemperatur aufweist, wobei eine derartige Struktur (5) umfasst:
- eine erste und eine zweite Zone (20, 60) von ein- und demselben Leitfähigkeitstyp, die aus einem ersten beziehungsweise einem zweiten Halbleitermaterial realisiert sind, wobei das erste und das zweite Halbleitermaterial beide aus den gleichen Elementen zusammengesetzt sind, wobei die Elemente Bestandteile darstellen, wobei ein unterschiedlicher Anteil an wenigstens zwei dieser Bestandteilselemente einem Unterschied der Breite des verbotenen Bands des Materials entspricht, wobei das erste Material ein Halbleitermaterial mit direkter Bandlücke ist,
- eine Barrierezone (40), die zwischen der ersten und der zweiten Zone (20, 60) angeordnet und dazu ausgelegt ist, als Barriere für die Majoritätsladungsträger der ersten und der zweiten Zone (20, 60) über eine Barrieredicke (*e*₁) zu dienen, wobei die Barrierezone (40) aus den Bestandteilselementen zusammengesetzt ist und über die gesamte Barrieredicke (*e*₁) ein Verhältnis an Bestandteilselementen derart aufweist, dass die Barrierezone (40) ein Minimum der Breite des verbotenen Bands größer als die Breite des verbotenen Bands der ersten Zone (20) aufweist, und die derart ist, dass der Absolutwert der Differenz zwischen der Energie des Extremums des Energiebands entsprechend dem Majoritätsladungsträger für das Minimum der Breite des verbotenen Bands der Barrierezone und der Energie dieses gleichen Extremums der zweiten Zone wenigstens gleich 10 Mal der thermischen Energie bei der nominalen Arbeitstemperatur ist, wobei das Verhältnis an Bestandteilselementen, für das die Barrierezone (40) die kleinste Breite des verbotenen Bands aufweist, das Barriereverhältnis (*X_{b}*) definiert,
wobei die Struktur (5) **dadurch gekennzeichnet ist, dass** sie eine erste Grenzflächenzone (30) umfasst, die dazu ausgelegt ist, eine Grenzfläche zwischen der ersten Zone (20) und der Barrierezone (40) über eine erste Grenzflächendicke (*e*₂) zu bilden, wobei die erste Grenzflächenzone eine Zusammensetzung an Bestandteilselementen aufweist, die für die gesamte Grenzflächendicke (*e*₂) und von der ersten Zone (20) hin zur Barrierezone (40) variiert von einem Verhältnis entsprechend jenem des ersten Materials zum Barriereverhältnis (*X_{b}*), wobei die erste Grenzflächendicke (*e*₂) wenigstens gleich der halben Barrieredicke (*e*₁) ist, und wobei eine zweite Grenzflächenzone (50) vorgesehen ist, die dazu ausgelegt ist, eine Grenzfläche zwischen der Barrierezone (40) und der zweiten Zone (60) über eine zweite Grenzflächendicke (*e*₃) zu bilden, wobei die zweite Grenzflächenzone (50) eine Zusammensetzung an Bestandteilselementen aufweist, die über die gesamte zweite Grenzflächendicke (*e*₃) und von der Barrierezone (40) hin zur zweiten Zone (60) variiert von dem Barriereverhältnis (*X_{b}*) zu einer Zusammensetzung entsprechend jener des zweiten Materials (*X*₂), wobei die zweite Grenzflächendicke (*e*₃) kleiner als die halbe Barrieredicke (*e*₁) ist.

2. Struktur (5) nach Anspruch 1, bei der die Struktur eine nBn-Struktur ist, das heißt dass die erste und die zweite Zone von dem Leitfähigkeitstyp sind, bei dem die Majoritätsladungsträger Elektronen sind, wobei die Barrierezone (40) aus den Bestandteilselementen zusammengesetzt ist und über die gesamte Barrieredicke (*e*₁) ein Verhältnis an Bestandteilselementen derart aufweist, dass die Barrierezone (40) ein Minimum der Breite des verbotenen Bands größer als die Breite des verbotenen Bands der ersten Zone (20) aufweist, und die derart ist, dass der Absolutwert der Differenz zwischen der Energie des Extremums des Energiebands entsprechend dem Majoritätsladungsträger für das Minimum der Breite des verbotenen Bands der Barrierezone und der Energie dieses gleichen Extremums des Leitungsbands der zweiten Zone wenigstens gleich 10 Mal der thermischen Energie bei der nominalen Arbeitstemperatur ist.

3. Struktur (5) nach Anspruch 1 oder 2, bei der das erste und das zweite Material im Wesentlichen identische Verhältnisse an Bestandteilselementen aufweisen.

4. Struktur (5) nach einem der vorhergehenden Ansprüche, bei der die Bestandteilselemente Cadmium (Cd), Quecksilber (Hg) und Tellur (Te) sind.

5. Struktur (5) nach einem der vorhergehenden Ansprüche, bei der die erste Grenzflächendicke (*e*₂) enthalten ist zwischen ein Mal die Barrieredicke (*e*₁) und zwei Mal die Barrieredicke (*e*₁).

6. Struktur (5) nach einem der vorhergehenden Ansprüche, bei der das Verhältnis an Bestandteilselementen im Wesentlichen gleichmäßig über die gesamte erste Grenzflächendicke (*e*₂) variiert.

7. Struktur (5) nach einem der vorhergehenden Ansprüche, bei der die zweite Grenzflächendicke (*e*₃) kleiner ist als ein Drittel der Barrieredicke (*e*₁), und vorzugsweise kleiner als ein Zehntel der Barrieredicke (*e*₁).

8. Struktur (5) nach einem der vorhergehenden Ansprüche, bei der die Barrieredicke (*e*₁) zwischen 100 und 300 nm enthalten ist.

9. Halbleitervorrichtung (1), umfassend eine Mehrzahl von Halbleiterstrukturen (5a,b,c,d), **dadurch gekennzeichnet, dass** wenigstens eine der Strukturen (5a,b,c,d) eine Struktur nach einem der vorhergehenden Ansprüche ist.

10. Halbleitervorrichtung (1) nach Anspruch 9, bei der ein Optikbereich (2) und ein Verarbeitungsbereich vorgesehen sind, wobei der Optikbereich (2) eine Mehrzahl von sogenannten optischen Halbleiterstrukturen (5a,b,c,d) umfasst, die dazu ausgelegt sind, eine elektromagnetische Strahlung (λ) zu empfangen und sie in ein elektrisches Signal umzuwandeln, wovon wenigstens eine der Strukturen (5a,b,c,d) wenigstens eine Struktur nach einem der Ansprüche 1 bis 8 ist, wobei der Verarbeitungsbereich Halbleiterstrukturen umfasst, die relativ zueinander dazu ausgelegt sind, die elektrischen Signale der optischen Strukturen (5a,b,c,d) zu verarbeiten.

11. Verfahren zur Herstellung einer Halbleiterstruktur nach einem der Ansprüche 1 bis 8, umfassend die folgenden Schritte:
- Bereitstellen einer ersten Zone (20) von einem ersten Leitfähigkeitstyp, die aus einem ersten Halbleitermaterial realisiert ist, wobei das erste Material aus sogenannten Bestandteilselementen derart zusammengesetzt ist, dass ein unterschiedliches Verhältnis an wenigstens zwei der Bestandteilselemente einer Variation der Breite des verbotenen Bands des Materials entspricht,
- Bilden einer ersten Grenzflächenzone (30) in Kontakt mit der ersten Zone (20), wobei die erste Grenzflächenzone (30) eine erste Grenzflächendicke (*e*₂) und eine Zusammensetzung an Bestandteilselementen aufweist, die über die gesamte Grenzflächendicke (*e*₂) variiert von einem Verhältnis entsprechend jenem des ersten Materials zu einem Barriereverhältnis,
- Bilden einer Barrierezone (40) in Kontakt mit der Grenzflächenzone (30) derart, dass die Grenzflächenzone (40) eine Grenzfläche zwischen der ersten Zone (20) und der Barrierezone (40) bildet, wobei die Barrierezone (40) eine Barrieredicke (*e*₁) aufweist, die wenigstens kleiner als zwei Mal die erste Grenzflächendicke (*e*₂) ist, wobei die Barrierezone (40) aus den Bestandteilselementen zusammengesetzt ist und über die gesamte Barrieredicke (*e*₁) ein Verhältnis derart aufweist, dass die Barrierezone (40) eine Breite des verbotenen Bands größer als jene der ersten Zone (20) besitzt, wobei das Verhältnis an Bestandteilselementen, für das die Barrierezone (40) die kleinste Breite des verbotenen Bands aufweist, gleich dem Barriereverhältnis (*X_{b}*) ist,
- Bilden einer zweiten Grenzflächenzone (50) über eine zweite Grenzflächendicke (*e*₃), wobei die Zusammensetzung an Bestandteilselementen der zweiten Grenzflächenzone von dem Barriereverhältnis (*X_{b}*) zu einem Verhältnis entsprechend jenem des zweiten Materials variiert, wobei die zweite Grenzflächendicke (*e*₃) kleiner als die halbe Barrieredicke (*e*₁) ist,
- Bilden einer zweiten Zone (60) von gleichen Leitfähigkeitstyp wie die erste Zone (20), wobei die zweite Zone (20), aus einem zweiten Halbleitermaterial realisiert ist, das aus den Bestandteilselementen zusammengesetzt ist, wobei die zweite Zone (60) derart ausgelegt ist, dass die Barrierezone (40) zwischen der ersten und der zweiten Zone (20, 60) angeordnet ist, wobei die Breite des verbotenen Bands der zweiten Zone (60) derart ist, dass der Absolutwert der Differenz zwischen der Energie des Extremums des Energiebands entsprechend dem Majoritätsladungsträger für das Minimum der Breite des verbotenen Bands der Barrierezone und der Energie dieses gleichen Extremums der zweiten Zone gleich wenigstens zehn Mal der thermischen Energie bei der nominalen Arbeitstemperatur ist.

## Claims

1. A semi-conducting structure (5) able to receive an electromagnetic radiation (λ) and to transform it into an electrical signal, said structure including an operating temperature rating, such a structure (5) including:
- a first and a second zone (20, 60) of a same conductivity type and respectively made of a first and a second semi-conductor material, said first and second semi-conductor materials both being constituted of the same elements, said elements being called constituent elements, a different proportion in at least two of these constituent elements corresponding to a bandgap energy difference of said material, the first material being a direct bandgap semi-conductor material,
- a barrier zone (40), provided between the first and second zones (20, 60), for acting as a barrier to the majority carriers of the first and the second zones (20, 60) on a barrier thickness (e₁), said barrier zone (40) being constituted of the constituent elements and having on the entire barrier thickness (e₁) a proportion of constituent elements such that the barrier zone (40) has a bandgap energy minimum higher than the bandgap energy of the first zone (20) and which is such that the difference in absolute value between the energy of the energy band extremum corresponding to the majority carrier for the bandgap energy minimum of the barrier zone and the energy of this same extremum of the second zone is equal to at least 10 times the heat energy at the operating temperature rating, the proportion of constituent elements for which the barrier zone (40) has the lowest bandgap energy defining the barrier proportion (X_{b}),
the structure (5) **being characterised in that** it includes a first interface zone (30) arranged to interface the first zone (20) and the barrier zone (40) on a first interface thickness (e₂), the first interface zone having a composition of constituent elements which is varied on the entire interface thickness (e₂) and from the first zone (20) to the barrier zone (40), from a proportion corresponding to that of the first material to the barrier proportion (X_{b}), the first interface thickness (e₂) being at least equal to half the barrier thickness (e₁) **and wherein** is provided a second interface zone (50) arranged to interface the barrier zone (40) and the second zone (60) on a second interface thickness (e₃), the second interface zone (50) having a composition of constituent elements which is varied, on the entire second interface thickness (e₃) and from the barrier zone (40) to the second zone (60), of the barrier proportion (X_{b}) to a composition corresponding to that of the second material (X₂), the second interface thickness (e₃) being lower than half the barrier thickness (e₁).

2. The structure (5) according to claim 1, wherein the structure is a nBn structure, that is the first and second zones are of the conductivity type for which the majority carriers are electrons, the barrier zone (40) being constituted of the constituent elements and having on the entire barrier thickness (e₁) a proportion of constituent elements such that the barrier zone (40) has a bangap energy minimum higher than the bandgap energy of the first zone (20) and which is such that the difference in absolute value between the energy of the energy band extremum corresponding to the majority carrier for the bandgap energy minimum of the barrier zone and the energy of this same extremum of the conduction band of the second zone is equal to at least 10 times the heat energy at the operating temperature rating.

3. The structure (5) according to claim 1 or 2, wherein the first and second materials have substantially identical proportions of constituent elements.

4. The structure (5) according to any of the preceding claims, wherein the constituent elements are cadmium (Cd), mercury (Hg) and tellurium (Te).

5. The structure (5) according to any of the preceding claims, wherein the first interface thickness (e₂) is between once the barrier thickness (e₁) and twice the barrier thickness (e₁).

6. The structure (5) according to any of the preceding claims, wherein the proportion of constituent elements is substantially evenly varied on the entire first interface thickness (e₂).

7. The structure (5) according to any of the preceding claims, wherein the second interface thickness (e₃) is lower than the third of the barrier thickness (e₁) and preferentially lower than the tenth of the barrier thickness (e₁).

8. The structure (5) according to any of the preceding claims, wherein the barrier thickness (e₁) is between 100 and 300 nm.

9. A semi-conducting device (1), including a plurality of semi-conducting structures (5a, b, c, d), **characterised in that** at least one of the structures (5a, b, c, d) is a structure according to any of the preceding claims.

10. The semi-conducting device (1) according to claim 9, wherein is provided an optical part (2) and a processing part, the optical part (2) including a plurality of semi-conducting structures (5a, b, c, d), called optical structures, able to receive an electromagnetic radiation (λ) and to transform it into an electrical signal, at least one of the structures (5a, b, c, d) being at least one structure according to one of claims 1 to 8, the processing part including semi-conducting structures arranged between them to process the electrical signals of the optical structures (5a, b, c, d).

11. A method for manufacturing a semi-conducting structure (5) according to one of claims 1 to 8, including the steps of:
- providing a first zone (20) of a first conductivity type and made of a first semi-conductor material, the first material being constituted of so-called constituent elements, such that a different proportion of at least two of said constituent elements corresponds to a variation in the bandgap energy of said material,
- forming a first interface zone (30) in contact with the first zone (20), the first interface zone (30) having a first interface thickness (e₂) and a composition of constituent elements which is varied on the entire interface thickness (e₂) from a proportion corresponding to that of the first material to a barrier proportion,
- forming a barrier zone (40) in contact with the interface zone (30) such that the interface zone (40) interfaces the first zone (20) and the barrier zone (40), the barrier zone (40) having a barrier thickness (e₁) at least lower than twice the first interface thickness (e₂), the barrier zone (40) being constituted of constituent elements and having on the entire barrier thickness (e₁) a proportion such that the barrier zone (40) has a bandgap energy gap higher than that of the first zone (20), the proportion of constituent elements for which the barrier zone (40) has the lowest bandgap energy being equal to the barrier proportion (X_{b}),
- forming a second interface zone (50) on a second interface thickness (e₃), the composition of constituent elements of the second interface zone being varied from the barrier proportion (X_{b}) to a proportion corresponding to that of the second material, the second interface thickness (e₃) being lower than half the barrier thickness (e₁),
- forming a second zone (60) of the same conductivity type as the first zone (20), the second zone (20) being made of a second semi-conductor material consisting of the constituent elements, the second zone (60) being arranged such that a barrier zone (40) is provided between the first and second zones (20, 60), the bandgap energy of the second zone (60) being such that the difference in absolute value between the energy of the energy band extremum corresponding to the majority carrier for the bandgap energy minimum of the barrier zone and the energy of the same extremum of the second zone is equal to at least 10 times the heat energy at the operating temperature rating.
